# EUROPÄISCHE PATENTSCHRIFT

(11) **EP 0 448 835 B1**
(45) Veröffentlichungstag und Bekanntmachung des Hinweises auf die Patenterteilung: **12.10.1994**
(21) Anmeldenummer: 90125313.8
(22) Anmeldetag: 22.12.1990
(51) Int. Cl.: H03D 1/22, H03B 27/00, H03K 5/15

(54) **Phasenteiler**
Phase splitter
Diviseur de phase

(30) Priorität: 27.03.1990 DE 4009784
(43) Veröffentlichungstag der Anmeldung: 02.10.1991
(73) Patentinhaber: TEMIC TELEFUNKEN microelectronic GmbH, 74072 Heilbronn (DE)
(72) Erfinder: Tränkle, Günther, Dipl.-Phys., W-7910 Neu-Ulm 7 (DE)
(74) Vertreter: Maute, Hans-Jürgen, Dipl.-Ing.

(56) Entgegenhaltungen:
- EP-A- 0 226 754
- EP-A- 0 308 071
- DD-B- 215 215
- US-A- 4 527 075

## Beschreibung

Die Erfindung betrifft einen Phasenteiler nach dem Oberbegriff des Patentanspruchs 1.

Signale mit gegenseitiger Phasenverschiebung von 90° sind beispielsweise von Bedeutung bei der Frequenzumsetzung in Quadraturmischern, insbesondere bei der Direktumsetzung in Modulatoren oder Demodulatoren. Master-Slave-D-Flip-Flops im Toggle-Betrieb können als 90°-Phasenteiler eingesetzt werden, indem der Ausgang der Master-Stufe das eine und der Ausgang der Slavestufe das andere der phasenverschobenen Signale liefert, wobei beide Signale gegenüber dem Eingangssignal frequenzhalbiert sind. Aufgrund dynamischer Effekte ist die 90°-Phasenbeziehung zwischen den beiden Ausgangssignalen aber vor allem für hohe Frequenzen nicht ohne weiteres gewährleistet.

Aus der EP 0 308 071 A2 ist eine Schaltungsanordnung bekannt, bei welcher ein Master-Slave-Flip-Flop aus einem Eingangssignal zwei gegeneinander phasenverschobene Ausgangssignale der halben Frequenz erzeugt. Die beiden Stufen des Flip-Flops sind durch je einen Stromschalter angesteuert, die mit dem Eingangssignal beaufschlagt sind und deren einander entsprechende Eingänge jeweils miteinander verbunden sind. Mittels einer Differenzspannung zwischen den Eingängen der Stromschalter kann die Schaltschwelle der Stromschalter verschoben und die Phasendifferenz zwischen den Ausgangssignalen eingestellt werden.

Aus der US-A-4 527 075 ist es bekannt, das Tastverhältnis eines Taktsignals zu stabilisieren, indem zwei komplementäre Signale tiefpaßgefiltert werden und eine daraus gewonnene Differenz-Gleichspannung in einer Regelschleife das Tastverhältnis regelt.

Aufgabe der vorliegenden Erfindung ist es daher, einen Phasenteiler der im Patentanspruch 1 genannten Art so auszubilden, daß mit einfachen Mitteln die Konstanz der 90°-Phasenbeziehungen der beiden Ausgangssignale gewährleistet ist.

Die erfindungsgemäße Lösung dieser Aufgabe ist durch die kennzeichnenden Merkmale des Patentanspruchs 1 gegeben. Die Unteransprüche enthalten vorteilhafte Ausgestaltungen und Weiterbildungen der Erfindung.

Die Erfindung macht sich die Erkenntnis zunutze, daß bei genau äquidistanten Schaltzeitpunkten der die Master- und Slave-Stufe ansteuernden, von dem Eingangssignal beaufschlagten Stromschalter die 90°-Phasenbeziehung in den Ausgangssignalen gewährleistet ist, so daß durch eine Regelung der Schaltzeitpunkte auf zeitliche Äquidistanz die gewünschte Phasenlage sichergestellt ist und nicht mehr überprüft zu werden braucht, und daß durch den Einsatz eines Regelkreises mit einem Stromschalter, der dieselben Schalteigenschaften aufweist wie die Stromschalter zur Ansteuerung der Flip-Flop-Stufen, dieses Ziel auf besonders vorteilhafte Weise erreicht werden kann.

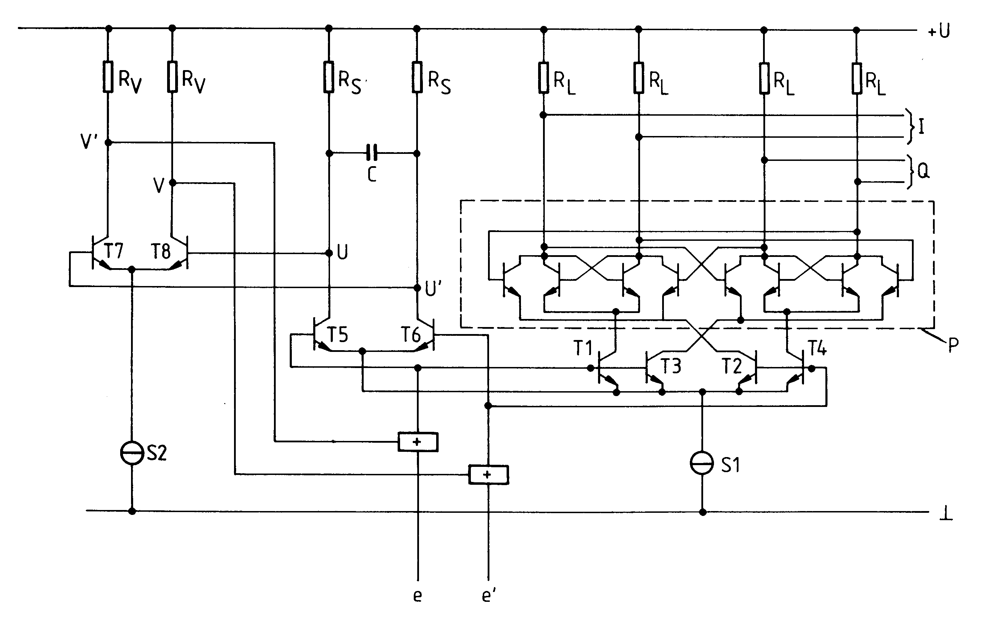

Die Erfindung ist nachfolgend anhand eines bevorzugten Ausführungsbeispiels unter Bezugnahme auf die Abbildung noch eingehend erläutert.

Das im Block P skizzierte Master-Slave-D-Flip-Flop als solches ist einschließlich seiner Funktion hinlänglich bekannt, weshalb die Transistoren im Block P nicht einzeln bezeichnet und die Wirkungsweise der einzelnen Rückkopplungen nicht weiter beschrieben sind. Andere Flip-Flop Schaltungen sind in entsprechender Weise verwendbar. An den über Lastimpedanzen R_{L} mit dem Versorgungspotential +U verbundenen Master- und Slave-Ausgängen sind die beiden 90°-phasenverschobenen Ausgangssignale I und Q abgegriffen.

Die Master- und Slave-Stufen sind durch zwei als Differenzverstärker ausgeführte Stromschalter T1, T2 bzw. T3, T4 angesteuert, deren Eingänge mit dem symmetrisch zugeführten Eingangssignal e, e′ beaufschlagt sind. Entsprechende Eingänge der beiden Differenzverstärker sind miteinander verbunden. (Basis von T1 mit Basis von T3; Basis von T2 mit Basis von T4.) Beide Differenzverstärker sind aus einer gemeinsamen Stromquelle S1 gespeist. Durch den hochsymmetrischen Aufbau und die bei monolithischer Integration gegebene Möglichkeit, einzelne Schaltungselemente in guter Genauigkeit mit gleichen Eigenschaften herzustellen, sind keine durch den Aufbau des Flip-Flops samt Stromschalter und Stromquelle verursachten Phasenfehler zu erwarten.

Phasenfehler treten aber auf, wenn das Tastverhältnis der Stromschalter ≠ 0,5 ist, d. h. wenn die Schaltzeitpunkte nicht zeitlich äquidistant liegen. Dies ist auf kaum mit vertretbarem Aufwand vermeidbare Verzerrungen des Eingangssignals e, e′ zurückzuführen, das wegen der 2:1-Frequenzteilerwirkung des als statischer Phasenteiler betriebenen Flip-Flops in vielen Fällen das Ausgangssignal eines Frequenzverdopplers ist.

Kann mittels eines Regelkreises ein Tastverhältnis von 0,5 eingeregelt werden, so ist auch die gewünschte 90°-Phasenlage der Ausgangsspannungen I und Q gewährleistet.

Im skizzierten bevorzugtem Beispiel ist zur Überwachung des Tastverhältnisses ein weiterer als Differenzverstärker aufgebauter Stromschalter mit Transistoren T5, T6 vorgesehen. Dieser Stromschalter soll dieselben Schalteigenschaften besitzen wie die Stromschalter T1, T2 und T3, T4, was wiederum bei monolithischer Integration mit guter Genauigkeit erzielt werden kann. Die Eingänge des weiteren Stromschalters T5, T6 sind mit den entsprechenden Eingängen der beiden anderen Stromschalter T1, T2 und T3, T4 unmittelbar verbunden und so ebenfalls mit dem Eingangssignal e, e′ beaufschlagt. Wesentlich ist, daß die Schaltzeitpunkte aller Stromschalter exakt übereinstimmen.

Zur weiteren Angleichung der dynamischen Eigenschaften des weiteren Stromschalters an die der anderen Stromschalter sind alle Stromschalter aus der gemeinsamen Stromquelle S1 gespeist.

Zwischen die über Lastwiderstände R_{S} mit dem Versorgungspotential verbundenen Ausgänge des weiteren Stromschalter T5, T6 ist eine Kapazität C geschaltet, die zusammen mit den Lastwiderständen einen Tiefpaß zur Mitteilung der Ausgangsspannung u, u′ des weiteren Stromschalters bildet.

Bei von 0,5 verschiedenen Tastverhältnis, z. B. bei länger aussteuernder positiver Halbwelle für e und kürzerer positiver Halbwelle im komplementären Signal e′ ist jeweils einer der beiden Transistoren aller drei Stromschalter länger geöffnet als der andere, bei dem weiteren Stromschalter im Beispielsfall der Transistor T5, so daß die gemittelte Ausgangsspannung u gegenüber u′ niedriger liegt.

Die Ausgangsspannungen u, u′ des weiteren Stromschalters T5, T6 sind an die Eingänge eines Regel-Differenzverstärkers zur Erhöhung der Schleifenverstärkung des Regelkreises und somit zur Minderung des Phasenrestfehlers mit Transistoren T7, T8 gelegt. Der Strom durch den Differenzverstärker ist durch die Stromquelle S2 festgelegt. Die Ausgänge des Regel-Differenzverstärkers sind über Lastwiderstände R_{V} mit Versorgungspotential +U verbunden. Die Ausgangsspannungen sind als Regelspannungen v, v′ angegeben.

Wenn u gegenüber u′ absinkt, so führt dies zu einem verstärkten Ansteigen von v und einem entsprechenden Absinken von v′. Die Regelspannungen wirken unmittelbar verschiebend auf die Gleichspannungspegel an den Eingängen der Stromschalter, so daß im Beispielsfall ein Anstieg von v zu einer Anhebung des Gleichspannungspegels an der Basis von T6 führt, was wiederum eine Verlängerung der aussteuernden Halbwelle von e′ und damit zu einer längeren Öffnungszeit des Transistors T6 und zum Absinken der Spannung u′ gegenüber u führt. Die entsprechende gegenteilige Rückwirkung einer Veränderung von v′ auf u führt zum Ansteigen von u und wirkt daher dem auslösenden Absinken von u entgegen. Der Regelkreis ist demnach bestrebt, die Spannungsdifferenz zwischen u und u′ zum Verschwinden zu bringen, was gleichbedeutend ist mit einem Tastverhältnis gleich 0,5 bzw. zeitlich äquidistanter Lage der Schaltzeitpunkte. Der beschriebene Regelkreis ist also mit einfachen Mitteln in der Lage, über die Einregelung des Tastverhältnisses in den Stromschaltern die 90°-Phasenlage in den Ausgangssignalen I und Q sicherzustellen.

Selbstverständlich kann auch eine unsymmetrische Ansteuerung der Stromschalter durch das Eingangssignal erfolgen, wobei dann einer der gemeinsamen Steueranschlüsse der Stromschalter auf konstantem Potential liegt. Die Regelfunktion bleibt in entsprechender Weise erhalten.

## Patentansprüche

1. Phasenteiler zur Erzeugung zweier gegenseitig um 90° phasenverschobener Ausgangssignale (I,Q) aus einem periodischen Eingangssignal doppelter Frequenz mit einem Master-Slave-D-Flip-Flop , dessen Master-Stufe und Slave-Stufe je eines der beiden Ausgangssignale liefern und durch je einen Stromschalter (T1, T2 bzw. T3, T4) angesteuert sind, deren einander entsprechende Eingänge miteinander verbunden und mit dem Eingangssignal beaufschlagt sind, und mit Mitteln zur Beeinflussung der Gleichspannungspegel an den Eingängen der Stromschalter, dadurch gekennzeichnet, daß zur Beeinflussung der Gleichspannungspegel an den Eingängen der Stromschalter ein Regelkreis vorgesehen ist, der die Schaltzeitpunkte der Stromschalter äquidistant einregelt, und daß der Regelkreis einen weiteren Stromschalter (T5, T6) enthält, der dieselben Schalteigenschaften wie die beiden erstgenannten Stromschalter besitzt und dessen Eingänge mit den entsprechenden Eingä ngender beiden anderen Stromschalter verbunden sind.

2. Phasenteiler nach Anspruch 1, dadurch gekennzeichnet, daß die Stromschalter als Differenzverstärker ausgeführt und mit einer gemeinsamen Stromquelle (S1) verbunden sind.

3. Phasenteiler nach Anspruch 1 oder 2, dadurch gekennzeichnet, daß als Ist-Wert des Regelkreises für die relative zeitliche Lage der Schaltzeitpunkte die tiefpaßgefilterten Ausgangsspannungen (u, u′) des weiteren Stromschalters ausgewertet werden.

4. Phasenteiler nach Anspruch 3, dadurch gekennzeichnet, daß die tiefpaßgefilterten Ausgangsspannungen des weiteren Stromschalters an die Eingänge eines Regel-Differenzverstärkers gelegt sind und die Spannungen (v,v′ ) an den Ausgängen des Regel-Differenzverstärkers die Gleichspannungspegel an den Eingängen der Stromschalter bestimmen.

## Claims

1. Phase splitter for producing two output signals (I, Q) which are mutually in quadrature from a periodic input signal of double the frequency, with a master-slave D-type flip-flop whose master stage and slave stage each deliver one of the two output signals and are triggered by a respective current switch (T1, T2 and T3, T4, respectively), the corresponding inputs of which are connected together and acted upon by the input signal, and with means for influencing the d.c. voltage levels at the inputs of the current switches, characterised in that a control circuit is provided to influence the d.c. voltage levels at the inputs of the current switches, which circuit makes the switching instants of the current switches equally spaced, and that the control circuit comprises an additional current switch (T5, T6), which has the same switching properties as the two first-mentioned current switches and the inputs of which are connected to the corresponding inputs of the two other current switches.

2. Phase splitter according to claim 1, characterised in that the current switches are formed as differential amplifiers and are connected to a common current source (S1).

3. Phase splitter according to claim 1 or 2, characterised in that the low-pass filtered output voltages (u, u′) of the additional current switch are evaluated as the actual value of the control circuit for the relative position in time of the switching instants.

4. Phase splitter according to claim 3, characterised in that the low-pass filtered output voltages of the additional current switch are applied to the inputs of a regulating differential amplifier, and the voltages (v, v′) at the outputs of the regulating differential amplifier determine the d.c. voltage levels at the inputs of the current switches.

## Revendications

1. Diviseur de phase servant à générer deux signaux de sortie (I, Q) mutuellement déphasés de 90° à partir d'un signal d'entrée périodique ayant la fréquence double, comprenant une bascule maître-esclave du type D, dont l'étage maître et l'étage esclave fournissent chacun l'un des deux signaux de sortie et sont pilotés chacun par un interrupteur de courant (T1, T2, respectivement T3, T4) dont les entrées homologues sont interconnectées et reçoivent le signal d'entrée, et comprenant des moyens pour influencer le niveau de la tension continue aux entrées des interrupteurs de courant, caractérisé en ce que, pour influencer les niveaux de tension continue aux entrées des interrupteurs de courant, on a prévu un circuit de réglage qui règle les instants de commutation des interrupteurs de courant pour qu'ils soient équidistants, et que le circuit de réglage contient un interrupteur de courant supplémentaire (T5, T6) qui possède les mêmes caractéristiques de commutation que les deux interrupteurs de courant mentionnés en premier et dont les entrées sont reliées aux entrées homologues des deux autres interrupteurs de courant.

2. Diviseur de phase selon la revendication 1, caractérisé en ce que les interrupteurs de courant sont réalisés comme des amplificateurs différentiels et reliés à une source de courant (S1) commune.

3. Diviseur de phase selon la revendication 1 ou 2, caractérisé en ce que, comme valeur réelle du circuit de réglage pour la position temporelle relative des instants de commutation, on utilise les tensions de sortie (u, u′), obtenues à la suite d'un filtre passe-bas, de l'interrupteur de courant supplémentaire.

4. Diviseur de phase selon la revendication 3, caractérisé en ce que les tensions de sortie de l'interrupteur de courant supplémentaire, obtenues à la suite d'un filtre passe-bas, sont appliquées aux entrées d'un amplificateur différentiel de réglage et les tensions (v, v′) aux sorties de cet amplificateur différentiel déterminent les niveaux de tension continue aux entrées des interrupteurs de courant.
